# EUROPÄISCHE PATENTSCHRIFT

(11) **EP 3 443 587 B1**
(45) Veröffentlichungstag und Bekanntmachung des Hinweises auf die Patenterteilung: **13.05.2020**
(21) Anmeldenummer: 17717121.2
(22) Anmeldetag: 07.04.2017
(51) Int. Cl.: H01L 21/683, H01L 23/544, H01L 21/67, H01L 21/673, H01L 23/538

(54) **VORRICHTUNG, SYSTEM UND VERFAHREN ZUM AUSRICHTEN ELEKTRONISCHER BAUTEILE**
APPARATUS, SYSTEM AND METHOD FOR ALIGNING ELECTRONIC COMPONENTS
APPAREIL, SYSTÈME ET MÉTHODE POUR ALIGNER DES COMPOSANTS ÉLECTRONIQUES

(30) Priorität: 14.04.2016 DE 102016004592
(43) Veröffentlichungstag der Anmeldung: 20.02.2019
(73) Patentinhaber: Mühlbauer GmbH & Co. KG, 93426 Roding (DE)
(72) Erfinder: BRANDL, Franz, 93455 Sattelpeilnstein Gemeinde Traitsching (DE); MONSER, Hans-Peter, 01277 Dresden (DE); NIKLAS, Sigmund, 93199 Zell (DE)
(74) Vertreter: Schmidt, Steffen J.
(86) Internationale Anmeldenummer: PCT/EP2017/058384
(87) Internationale Veröffentlichungsnummer: WO 2017/178364

(56) Entgegenhaltungen:
- EP-A1- 2 765 431
- EP-A1- 2 884 293
- JP-A- S6 461 031
- JP-A- H05 104 380
- JP-A- 2006 177 755
- KR-A- 20140 014 441
- US-A1- 2002 093 080
- US-A1- 2006 154 386
- US-A1- 2011 043 231

## Beschreibung

### Hintergrund

Hier wird eine Vorrichtung, ein diese Vorrichtung enthaltendes System und ein Verfahren zum Ausrichten eines elektronischen Bauteils vorgestellt. Dabei wird ein elektronisches Bauteil mittels einer Ausrichteinrichtung an einer auf einem Träger befindlichen Ausrichtstruktur ausgerichtet.

### Stand der Technik

US 2010/0258543 A1 offenbart eine Abgabeeinrichtung und ein Abgabeverfahren für elektronische Bauteile von einem Wafer mittels eines Lasers. Die dadurch abgegebenen elektronischen Bauteile landen nach einer Freifallphase beispielsweise auf einem Foliensubstrat.

DE 10 2009 020 540 A1 offenbart eine Vorrichtung, die auf ein Foliensubstrat gelandete elektronische Bauteile automatisch ausrichtet. Dafür ist jeweils eine Landezone an dem Foliensubstrat für ein elektronisches Bauteil vorgesehen. Eine solche Landezone stellt eine rechteckige Grundfläche dar, die von einer umlaufenden Wand eingeschlossen ist, wobei ein zu einer der Grundfläche gegenüberliegenden Seite offenes Becken entsteht. Dieses Becken ist mit einem Adhäsiv gefüllt, das aufgrund der Oberflächenspannung leicht über den Rand der Wand reicht, ohne das Becken zu verlassen. Elektronische Bauteile, die auf dieses Adhäsiv landen, werden aufgrund des Effekts der Minimierung der freien Grenzflächenenergie im Bereich des Adhäsivs automatisch angeordnet und ausgerichtet.

WO 2010/036304 A2 offenbart hingegen ein Verfahren, bei welchem elektronische Bauteile von einem Wafer mittels eines Lasers abgegeben werden und nach einer Freifallphase in Taschen/Becken eines Bauteilsubstrats landen. Auch hier ist die adhäsive Verbindung des gelandeten elektronischen Bauteils mit dem Bauteilsubstrat vorgeschlagen.

Das US Patent 6,683,416 B1 zeigt ein Verfahren zur Übertragung von elektronischen Bauteilen von einem ersten Substrat auf ein zweites Substrat. Hierbei werden die Substrate zunächst übereinander angeordnet, sodass die auf einer Oberfläche des ersten Substrates befindlichen elektronischen Bauteile dem zweiten Substrat zugewandt sind. Ein elektronisches Bauteil wird mit Hilfe eines Lasers vom ersten Substrat gelöst und auf das zweite Substrat übertragen.

Das Dokument WO 01/33621 A2 zeigt eine Methode und eine Vorrichtung zum Erstellen von Ausnehmungen in einem Substrat. Das Dokument offenbart auch ein Selbstausrichtungsverfahren für Bauteile, welche auf dem Substrat mit Öffnungen anzuordnen sind, wobei die Bauteile zum Beispiel mit Hilfe der Schwerkraft auf dem gekippten Substrat entlang gleiten. Zur Verbesserung dieses Verfahrens schlägt das Dokument weiter eine Vibration des Substrates vor, sodass eine Bewegung der Bauteile auf dem Substrat befördert wird.

Weiterer Stand der Technik ist aus US 8,361,268 B2 , JPS61113243-A, JP2006128585-A, JP2006332378-A und JP2011096961-A bekannt.

Die vorgestellte Lösung betrifft insbesondere auch die Fertigung von LED-Farbdisplay-Anzeigetafeln, die aus mehreren Panels zusammengesetzt werden. Ein Panel (starr oder flexibel) hat zum Beispiel 8 Mio. Pixel. Ein Pixel besteht aus 3 LEDs, nämlich rot, grün und blau. Das heißt, ein Panel ist mit 24 Mio. LEDs zu bestücken, was durch das bekannte sequentielle Bestücken sehr aufwendig und zeitintensiv wäre.

### Zugrunde liegendes Problem

Ziel ist es, ein zuverlässiges und effizientes Ausrichten eines elektronischen Bauteils an einem Träger zu erreichen, das insbesondere für eine temporäre Ausrichtung mehrerer elektronischer Bauteile auf einem Träger geeignet ist.

### Lösung

Um dieses Ziel zu erreichen, werden hier eine Vorrichtung, ein diese Vorrichtung enthaltendes System sowie ein Verfahren mit den Merkmalen der jeweiligen unabhängigen Ansprüche vorgestellt.

Eine derartige Vorrichtung zum Ausrichten eines elektronischen Bauteils hat einen Träger mit einer Ausrichtstruktur für ein elektronisches Bauteil, und eine Ausrichteinrichtung zum Ausrichten des elektronischen Bauteils an der Ausrichtstruktur, wobei die Ausrichtstruktur eine erste und eine zweite Kante definiert, die im Winkel zueinander stehen und zu zwei im gleichen Winkel zueinander stehenden Seiten des auszurichtenden elektronischen Bauteils komplementär sind, wobei die Ausrichteinrichtung dazu eingerichtet ist, das elektronische Bauteil an der Ausrichtstruktur durch in Anlage bringen von Seiten des elektronischen Bauteils sowohl mit der ersten als auch mit der zweiten Kante der Ausrichtstruktur auszurichten. Die eingangs beschriebene Vorrichtung ermöglicht mittels der Ausrichtstruktur und der Ausrichteinrichtung eine präzise Anordnung und Ausrichtung eines oder auch einer Vielzahl elektronischer Bauteile, die lediglich annähernd genau auf einem Träger abgelegt worden sind. Zu diesem Zweck ist die Vorrichtung leicht und kostengünstig herstellbar.

Vorteilhaft ist es, wenn der Träger eine Vielzahl Ausrichtstrukturen in einer bestimmten geometrischen Verteilung für eine Vielzahl elektronischer Bauteile aufweist. So können gleich mehrere auf einem Träger zunächst grob angeordnete und ausgerichtete elektronische Bauteile in einem Vorgang präzise in einem von den Ausrichtstrukturen vorgegebenen Muster/Raster ausgerichtet werden.

Die Ausrichteinrichtung kann dazu eingerichtet sein, das elektronische Bauteil an der Ausrichtstruktur passiv und/oder aktiv auszurichten. Passives Ausrichten geschieht beispielsweise mittels geneigter Flächen am Träger, an denen das elektronische Bauteil zur Ausrichtstruktur gleitet. Aktives Ausrichten geschieht beispielsweise mittels einer Neigungsvorrichtung und/oder einer Vibrationseinrichtung am Träger, welche dazu eingerichtet sind, den Träger in Bewegung zu versetzen, um das elektronische Bauteil aus einer Ruhelage auf dem Träger in Anlage mit der Ausrichtstruktur zu bringen.

Dabei kann die Ausrichteinrichtung eine Neigungseinrichtung aufweisen, die dazu eingerichtet ist, das elektronische Bauteil an der Ausrichtstruktur auszurichten. Auf diese Weise wird das elektronische Bauteil aufgrund seines Eigengewichts und der Schwerkraft automatisch ausgerichtet.

In einer Ausführungsform kann die Ausrichtstruktur weiter einen Magneten aufweisen, welcher ein magnetisches Feld hervorruft, welches eine magnetische Kraft auf das insbesondere ferromagnetische Bauteil ausübt. Die magnetische Kraft kann hierbei im Wesentlichen gleichgerichtet zu der Schwerkraft sein. Das automatische Ausrichten des Bauteils kann so durch das hervorgerufene magnetische Feld bzw. die ausgeübte magnetische Kraft zumindest befördert werden.

In einer Variante kann die Ausrichtstruktur um eine erste Achse rotiert werden, welche orthogonal zu einer ausgedehnten Oberfläche der Ausrichtstruktur verläuft. Auf diese Weise wirkt eine Radialkraft auf das elektronische Bauteil, welche die Ausrichtung des Bauteils an der Ausrichtstruktur zumindest befördert.

Zum obigen Zweck kann die Neigungseinrichtung dazu eingerichtet sein, den Träger aus einer waagerechten Lage an mindestens einem Punkt zu heben und/oder zu senken, um das elektronische Bauteil aufgrund der resultierenden Neigung des Trägers an der Ausrichtstruktur auszurichten. So kann der Träger einfach und kostengünstig mit einer im Wesentlichen ebenen Oberfläche hergestellt werden, auf welcher das elektronische Bauteil gegen die Ausrichtstruktur gleiten kann.

Der Träger kann auch an zwei Punkten angehoben und/oder abgesenkt werden, um den Träger zu neigen, sodass das elektronische Bauteil zuerst gegen die eine Kante und anschließend auch gegen die andere Kante gleiten kann, damit es sich sowohl mit der ersten als auch mit der zweiten Kante der Ausrichtstruktur in Anlage befindet.

Zusätzlich oder an Stelle einer Neigungseinrichtung für den Träger kann die Neigungseinrichtung mindestens eine am Träger angeordnete zur Ausrichtstruktur geneigte Fläche aufweisen. Dadurch könnte die Gleitbewegung des elektronischen Bauteils zur Ausrichtstruktur unterstützt oder sogar gänzlich übernommen werden, sodass auf die Neigungseinrichtung für den Träger auch verzichtet werden könnte.

Ebenso kann der Träger zwei vorzugsweise übereinanderliegende Trägerplatten aufweisen, die zusammen eine Aufnahme für das elektronische Bauteil definieren und dazu eingerichtet sind, gegeneinander vorzugsweise in mindestens eine Richtung verschoben zu werden, um das elektronische Bauteil an der Ausrichtstruktur auszurichten. Eine derartige Ausrichtung erfordert keine Neigung des Trägers, was den Raumbedarf der Vorrichtung verringert, und ist nicht auf die Schwerkraft und das Eigengewicht des elektronischen Bauteils zum Ausrichten des elektronischen Bauteils angewiesen, was bei sehr leichten elektronischen Bauteilen vorteilhaft ist.

Dabei kann die Ausrichteinrichtung dazu eingerichtet sein, nur eine der beiden Trägerplatten gegenüber der anderen Trägerplatte zu verschieben. Dies vereinfacht den Aufbau der Vorrichtung und die Steuerung der Ausrichteinrichtung im Vergleich zu einer Ausrichteinrichtung, die beide Trägerplatten gegeneinander verschieben kann.

In den obigen Ausführungen kann die Aufnahme eine Durchgangsöffnung in der oberen Trägerplatte und eine Vertiefung in der unteren Trägerplatte sein. So kann das elektronische Bauteil vor dem Ausrichten sicher vom Träger umgriffen sein, um ein Abgleiten vom Träger vor dem Ausrichten zu vermeiden.

Diese Durchgangsöffnung in der oberen Trägerplatte kann größer sein als die Vertiefung in der unteren Trägerplatte. Dadurch kann das elektronische Bauteil zunächst innerhalb zumindest der Durchgangsöffnung und auf einer Oberseite der unteren Trägerplatte abgegeben werden, sodass es vom Träger sicher umfasst ist, bevor es aufgrund einer gegenseitigen Verschiebung beider Trägerplatten in die Vertiefung der unteren Trägerplatte fällt.

Dabei können von einer Grundfläche der Vertiefung beabstandete Kanten die Ausrichtstruktur bilden. Somit würden diese Kanten der zuverlässigen Einschließung und der präzisen Ausrichtung des elektronischen Bauteils dienen.

Die obere Trägerplatte kann in einem Querschnitt eine höhere oder eine geringere Dicke aufweisen als das Bauteil. Als Dicke ist hierbei die Ausdehnung der Trägerplatte bzw. des Bauteils von einer ausgedehnten Oberfläche zur jeweils gegenüberliegenden ausgedehnten Oberfläche zu verstehen.

In einer Ausführungsform kann die Durchgangsöffnung in der oberen Trägerplatte eine, insbesondere in einem Querschnitt, konisch verlaufende Form aufweisen. Hierbei kann die Durchgangsöffnung auf der der unteren Trägerplatte abgewandten Oberfläche der oberen Trägerplatte einen größeren Querschnitt aufweisen als auf der der unteren Trägerplatte zugewandten Oberfläche der oberen Trägerplatte. Die Durchgangsöffnung kann insbesondere kegelabschnittsförmig oder pyramidenabschnittsförmig sein, wobei sich die Durchgangsöffnung zur unteren Trägerplatte hin verjüngt. Die automatische Ausrichtung der Bauteile durch die Schwerkraft und/oder durch die magnetische Kraft wird somit befördert.

In einer alternativen Ausführungsform kann die Aufnahme durch eine Öffnung in der oberen Trägerplatte gebildet sein, während die untere Trägerplatte keine Vertiefungen aufweist.

Die genannten Ausführungsformen können derart weitergebildet werden, dass die Ausrichteinrichtung eine Vibrationseinrichtung aufweist, welche dazu eingerichtet ist, das elektronische Bauteil mittels Vibrationen des Trägers an der Ausrichtstruktur auszurichten.

Solche Vibrationen können obige Ausrichteinrichtungen unterstützen oder an deren Stelle dazu führen, dass das elektronische Bauteil an der Ausrichtstruktur ausgerichtet wird, wobei der Verzicht auf eine Neigungsvorrichtung Platz spart.

Zu diesem Zweck kann die Ausrichtstruktur L-förmig, rechteckig oder quadratisch sein. Eine L-förmige Ausrichtstruktur ist relativ günstig herzustellen, da vergleichsweise wenige Kanten und Flächen präzise gefertigt werden müssen. Eine rechteckige Ausrichtstruktur kann hingegen vielseitig eingesetzt werden, z.B. um vier verschiedene L-förmige Ausrichtstrukturen zu definieren, wobei jede dieser vier möglichen Ausrichtstrukturen von zwei unter einem rechten Winkel aufeinandertreffende Seiten gebildet werden. Eine quadratische Ausrichtstruktur ist darüber hinaus vielen quaderförmigen elektronischen Bauteilen mit einer quadratischen Unterseite nachempfunden, sodass eine schnellere Ausrichtung möglich ist, aufgrund der kürzeren Abstände im Vergleich zu einer nichtquadratischen rechteckigen Ausrichtstruktur.

Ein System zum Ausrichten eines elektronischen Bauteils hat eine der obigen Vorrichtungen zum Ausrichten eines elektronischen Bauteils und zusätzlich eine Abgabeeinrichtung, die dazu eingerichtet ist, ein elektronisches Bauteil an einer Abgabestelle über der Vorrichtung nahe einer Ausrichtstruktur abzugeben.

Das System kann zusätzlich eine Aufnahmeeinrichtung haben, die dazu eingerichtet ist, das in der Vorrichtung an der Ausrichtstruktur ausgerichtete elektronische Bauteil aufzunehmen. Eine derartige Aufnahmeeinrichtung kann aufgrund der wiederholt präzisen Anordnung und Ausrichtung eines elektronischen Bauteils auf dem Träger das elektronische Bauteil sehr zuverlässig aufnehmen.

Ein Verfahren zum Ausrichten eines elektronischen Bauteils, das zum Beispiel eine der obigen Vorrichtungen oder eines der obigen Systeme verwendet, hat folgende Schritte:
- Ausrichten eines auf einem Träger befindlichen elektronischen Bauteils an eine Ausrichtstruktur mittels einer Ausrichteinrichtung, und
- Verschieben des elektronischen Bauteils beim Ausrichten auf dem Träger mittels der Ausrichteinrichtung, sodass zwei im Winkel zueinander stehende Seiten des elektronischen Bauteils sowohl an einer ersten als auch an einer zweiten Kante der Ausrichtstruktur anliegen.

### Kurzbeschreibung der Figuren

Weitere Merkmale, Eigenschaften, Vorteile und mögliche Abwandlungen dieser elektrischen Maschine werden anhand der nachstehenden Beschreibung verdeutlicht, in der auf die beigefügten Zeichnungen Bezug genommen ist.

Die hier beschriebenen Varianten des Systems und der Vorrichtung sowie deren Funktions- und Betriebsaspekte dienen lediglich dem besseren Verständnis ihrer Struktur, Funktionsweise und Eigenschaften; sie schränken die Offenbarung nicht etwa auf die Ausführungsformen ein. Die Fig. sind teilweise schematisch, wobei wesentliche Eigenschaften und Effekte zum Teil deutlich vergrößert dargestellt sind, um die Funktionen, Wirkprinzipien, technischen Ausgestaltungen und Merkmale zu verdeutlichen. Dabei kann jede Funktionsweise, jedes Prinzip, jede technische Ausgestaltung und jedes Merkmal, welches/welche in den Fig. oder im Text offenbart ist/sind, mit allen Ansprüchen, jedem Merkmal im Text und in den anderen Fig., anderen Funktionsweisen, Prinzipien, technischen Ausgestaltungen und Merkmalen, die in dieser Offenbarung enthalten sind oder sich daraus ergeben, frei und beliebig kombiniert werden, so dass alle denkbaren Kombinationen den beschriebenen Vorrichtungen zuzuordnen sind. Dabei sind auch Kombinationen zwischen allen einzelnen Ausführungen im Text, das heißt in jedem Abschnitt der Beschreibung, in den Ansprüchen und auch Kombinationen zwischen verschiedenen Varianten im Text, in den Ansprüchen und in den Fig. umfasst und können zu Gegenstand weiterer Ansprüche gemacht werden. Auch die Ansprüche limitieren nicht die Offenbarung und damit die Kombinationsmöglichkeiten aller aufgezeigten Merkmale untereinander. Alle offenbarten Merkmale sind explizit auch einzeln und in Kombination mit allen anderen Merkmalen hier offenbart. Dabei zeigen:
Fig. 1 einen Abgabevorgang elektronischer Bauteile auf einen Träger;
Fig.2a einen Aufnahmevorgang bereits auf dem Träger ausgerichteter elektronischer Bauteile mittels eines Aufnahmewerkzeugs;
Fig. 2b einen Aufnahmevorgang bereits auf dem Träger ausgerichteter elektronischer Bauteile mittels eines Foliensubstrats;
Fig. 3a eine Draufsicht auf einen Träger mit L-förmigen Ausrichtstrukturen gemäß einer ersten Ausführungsform;
Fig. 3b eine perspektivische Sicht auf einen Teil des Trägers aus Fig. 3a mit einem an der Ausrichtstruktur ausgerichteten elektronischen Bauteil;
Fig. 3c eine seitliche Schnittansicht der in Fig. 3b gezeigten Schnittebene A-A durch den Träger mit einem Teil der Ausrichtstruktur und dem elektronischen Bauteil;
Fig. 3d vier Modifikationen der Ausrichtstruktur der ersten Ausführungsform;
Fig. 4a eine perspektivische Sicht auf einen anfänglichen Schritt des Ausrichtvorgangs gemäß der ersten Ausführungsform, wobei sich das elektronische Bauteil im freien Fall auf den Träger befindet;
Fig. 4b einen auf Fig. 4a folgenden Schritt, wobei das elektronische Bauteil bereits mit einer Unterseite auf dem Träger nahe der Ausrichtstruktur liegt;
Fig. 4c einen auf Fig. 4b folgenden Schritt, wobei der Träger geneigt wird, um das elektronische Bauteil gegen die Ausrichtstruktur gleiten zu lassen;
Fig. 4d einen auf Fig. 4c folgenden Schritt, wobei das elektronische Bauteil bereits mit der Ausrichtstruktur in Anlage gebracht worden ist, sodass dessen Ausrichtung abgeschlossen ist;
Fig. 5a eine Draufsicht auf einen Träger mit L-förmigen Ausrichtstrukturen und L-förmigen Ausrichteinrichtungen gemäß einer zweiten Ausführungsform;
Fig. 5b eine perspektivische Sicht auf eine Vertiefung des Trägers aus Fig. 5a;
Fig. 5c eine seitliche Schnittansicht der in Fig. 5b gezeigten Schnittebene B-B durch den Träger mit einem Teil der Ausrichtstruktur und einem Teil der Ausrichteinrichtung;
Fig. 5d eine Modifikation der Ausrichteinrichtung der zweiten Ausführungsform;
Fig. 6a eine perspektivische Sicht auf einen anfänglichen Schritt des Ausrichtvorgangs gemäß der zweiten Ausführungsform, wobei sich das elektronische Bauteil im freien Fall auf den Träger befindet;
Fig. 6b einen auf Fig. 6a folgenden Schritt, wobei zwei Kanten der Unterseite des elektronischen Bauteils auf den geneigten Flächen der Ausrichteinrichtung liegen;
Fig. 6c einen auf Fig. 6b folgenden Schritt, wobei das elektronische Bauteil entlang der geneigten Flächen gegen die Ausrichtstruktur ausgerichtet ist;
Fig. 6d zwei weitere Modifikationen der zweiten Ausführungsform;
Fig. 7a eine Draufsicht auf einen zweiteiligen Träger mit Ausrichtstrukturen gemäß einer dritten Ausführungsform;
Fig. 7b eine perspektivische Sicht auf einen Teil des Trägers aus Fig. 7a;
Fig. 7c eine seitliche Schnittansicht der in Fig. 7b gezeigten Schnittebene C-C durch den Träger mit einem Teil der Ausrichtstruktur;
Fig. 7d eine Modifikation der dritten Ausführungsform;
Fig. 7e eine perspektivische Sicht auf einen Teil des Trägers aus Fig. 7d;
Fig. 7f eine seitliche Schnittansicht der in Fig. 7e gezeigten Schnittebene C-C durch den Träger mit einem Teil der modifizierten Ausrichtstruktur;
Fig. 7g eine Weiterbildung der Modifikation der dritten Ausführungsform, welche einen Magneten aufweist;
Fig. 8a eine perspektivische Sicht auf einen anfänglichen Schritt des Ausrichtvorgangs gemäß der dritten Ausführungsform, wobei sich das elektronische Bauteil im freien Fall auf den Träger befindet;
Fig. 8b einen auf Fig. 8a folgenden Schritt, wobei das elektronische Bauteil mit einer Unterseite auf dem Träger liegt und mittels einer oberen Trägerplatte an einer ersten Kante einer unteren Trägerplatte ausgerichtet ist;
Fig. 8c einen auf Fig. 8b folgenden Schritt, wobei das elektronische Bauteil mittels der oberen Trägerplatte zusätzlich an einer zweiten Kante der unteren Trägerplatte ausgerichtet ist; und
Fig. 8d eine weitere Modifikation der dritten Ausführungsform, bei der die Ausrichtung des elektronischen Bauteils zusätzlich mittels einer Vibrationseinrichtung erfolgt.

### Detaillierte Beschreibung der Figuren

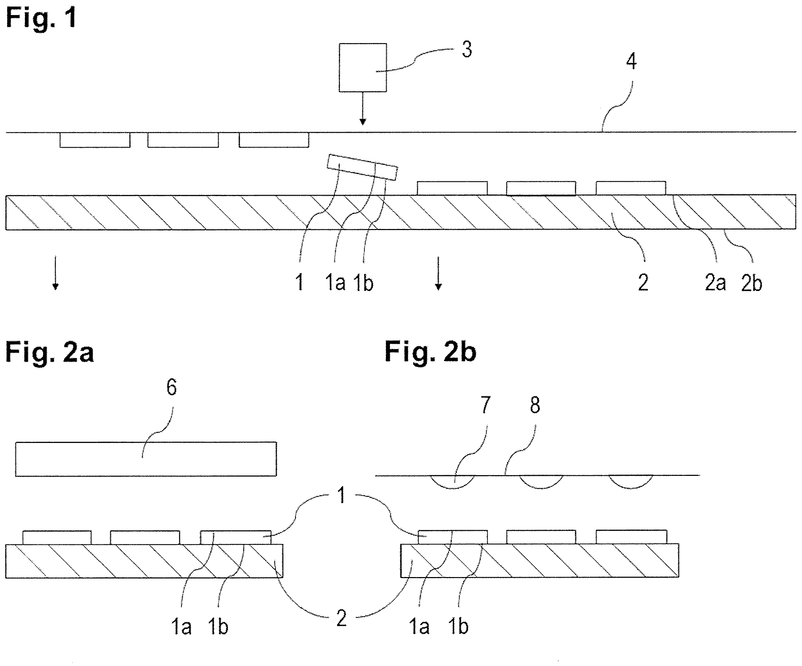

Fig. 1 zeigt einen Abgabevorgang/Ablöseprozess eines elektronischen Bauteils 1 (z.B. LED-Chip), der eine Oberseite 1a und eine Unterseite 1b hat, auf einen Träger 2 mit einer Oberseite 2a und einer Unterseite 2b, der in diesem Fall ein Zwischenträger ist. Die Abgabe erfolgt mittels Wärmeerzeugung durch einen Laser 3, der das elektronische Bauteil 1 sequentiell von einem Wafer 4 mit mehreren elektronischen Bauteilen 1 löst. Das vom Wafer 4 gelöste elektronische Bauteil 1 fällt anschließend nach einer kurzen Freifallphase mit einer vorbestimmten Unterseite 1b auf die Oberseite 2a des Trägers 2. Diese Freifallphase ist aufgrund der Nähe des Trägers 2 zum Wafer 4 an der Abgabestelle so kurz, dass das elektronische Bauteil 1 zuverlässig mit der vorbestimmten Unterseite 1b die Oberseite 2a des Trägers 2 berührt.

Die elektronischen Bauteile 1 werden also durch Wärmeeintrag von einem Laser 3 von einer auf dem Wafer 4 aufgebrachten Trägerfolie gelöst. Bei der Trägerfolie kann es sich um ein "Thermal Release Tape" / Folie mit thermisch freigebendem Haftklebstoff oder ein "UV-Tape" / Folie mit auf UV-Bestrahlung freigebendem Haftklebstoff handeln. Selbst von einer Trägerfolie mit reiner drucksensitiver Klebstoffbeschichtung können elektronischen Bauteile 1 auf diese Weise berührungslos abgelöst werden. Dabei wird der Wafer 4 so angeordnet, dass die elektronischen Bauteile 1 nach ihrem Lösen (frei) fallen können. Der Laser 3 ist dabei meist fest in einer Vorrichtung angeordnet. Vor dem Lösen werden das zu lösende elektronische Bauteil 1 und der Träger 2 zum Laserstrahl ausgerichtet. Die Kontrolle der Position des elektronischen Bauteils 1 erfolgt visuell mit Hilfe eines Bilderkennungssystems (PRS - "Pattern Recognition System"), wobei in einer Variante eine Kamera senkrecht auf den Wafer 4 blickt und der Laser 3 über einen Umlenkspiegel eingekoppelt sowie seitlich angeordnet ist. Alternativ ist der Laser 3 senkrecht angeordnet und die Kamera blickt schräg auf den Wafer 4. Der Wafer 4 ist beweglich angeordnet. Seine Positionierung wird über das PRS geregelt. Auf dem Wafer 4 sind elektronische Bauteile 1 einer oder verschiedener Art angeordnet. Die elektronischen Bauteile 1 fallen auf den Träger 2, der an Stelle eines üblicherweise verwendeten Zielsubstrates unter dem Wafer 4 angeordnet ist. Sind Wafer 4, Laser 3 und Träger 2 zueinander ausgerichtet, erfolgt die Bestrahlung. Der Träger 2 kann während seiner Bestückung kontinuierlich oder schrittweise bewegt werden. Bei kontinuierlicher Bewegung des Trägers 2 startet die Bestrahlung vor Erreichen der Position des Trägerbandes. Die Vorhaltezeit ergibt sich aus der Summe der Ablöse- und Fallzeit.

Beim Ablösen wird die Vorrichtung, die den Wafer 4, Laser 3 und Träger 2 aufweist, im nicht bewegt, dazu können oberhalb des Wafers 4 zwei Umlenkspiegel angeordnet sein. Es gibt auch so genannte Galvoköpfe, bei denen ist ein Spiegel vorhanden, der gekippt werden kann. Danach sind noch Linsen angeordnet, die den Laserstrahl in ihrem Durchmesserbereich trotz schräger Ablenkung wieder senkrecht umleiten.

Fig. 2a und Fig. 2b zeigen zwei Möglichkeiten der Weiterverarbeitung von auf dem Träger 2 abgelegten elektronischen Bauteilen 1. Je nach benötigter Orientierung (oben/unten) der elektronischen Bauteile 1 können diese simultan direkt auf ein Zielsubstrat übertragen werden oder indirekt durch flächenhafte Aufnahme und Übertragung auf das Zielsubstrat mit Hilfe eines Transferwerkzeugs.

In Fig. 2a werden die elektronischen Bauteile 1 von einer Aufnahmeeinrichtung 6, d.h. einem "Pick & Place Head" oder Stempel als Transferwerkzeug, aufgenommen, sodass sie mit ihrer Unterseite 1b beispielsweise auf einem Zielsubstrat abgelegt und mit diesem fest verbunden werden können. Das Transferwerkzeug 6 ist eben und nimmt ein elektronisches Bauteil 1 über Ansaugen, Elektrostatik oder durch Adhäsion auf. Seine Fläche zum Halten der elektronischen Bauteile 1 ist möglichst groß dimensioniert, um einen maximalen Bestück-Durchsatz zu erzielen. Beispielsweise kann die Fläche des Transferwerkzeugs 6 der Fläche des Trägers 2 oder des Zielsubstrats (Panel) entsprechen.

In Fig. 2b werden die elektronischen Bauteile 1 von einem mit einem Verbindungsmittel 7 benetzten Zielsubstrat 8 aufgenommen, sodass das Zielsubstrat 8 mit der Oberseite 1a der elektronischen Bauteile 1 fest verbunden wird. Diese Direktübertragung kann z.B. so erfolgen, dass an den Bestückpositionen zuvor flüssiger Klebstoff als Verbindungsmittel 7 in Form tröpfchenartiger Klebstoffdepots aufgetragen ist. Das Zielsubstrat 8 wird hängend von oben dem Träger 2 zugeführt. Die gebildeten Klebstoffdepots 7 sind in der Lage über Benetzung der elektronischen Bauteile 1, diese aus dem Träger 2 zu entnehmen. Die elektronischen Bauteile 1 sind dafür ausreichend leicht. Es besteht jedoch eine Gefahr der Verschmutzung des Trägers 2 mit dem flüssigen Klebstoff, insbesondere wenn sich die elektronischen Bauteile 1 in Vertiefungen im Träger 2 befinden. Durch Auftragen von Silberleitpaste per Siebdruck als Verbindungsmittel 7 anstelle des flüssigen Klebstoffs kann die Verschmutzungsgefahr reduziert werden.

Der Transfer elektronischer Bauteile 1 vom Wafer 4 auf den Träger 2 und die Ausrichtung der elektronischen Bauteile 1 am Träger 2 können zur selben Zeit erfolgen, wie die Übertragung der elektronischen Bauteile 1 aus dem Träger 2 auf das Zielsubstrat 8. Dazu kommen mehrere Träger 2 zum Einsatz. Außerdem kann es zwei Arbeitspositionen geben, die des Transfers elektronischer Bauteile 1 und die der Übertragung auf das Substrat 8. Dafür wird ein Transportsystem verwendet.

Alternativ können die Transportstrecken für die Träger 2 und für die Zielsubstrate parallel nebeneinander laufen. Während die Bestückung durchgeführt wird, kann der nachfolgende Ablöseprozess auf einem weiteren Träger 2 durchgeführt werden. Deshalb kann der Transport des vorhergehenden Trägers 2 vom Träger 2 unterhalb des Wafers 4 entkoppelt sein.

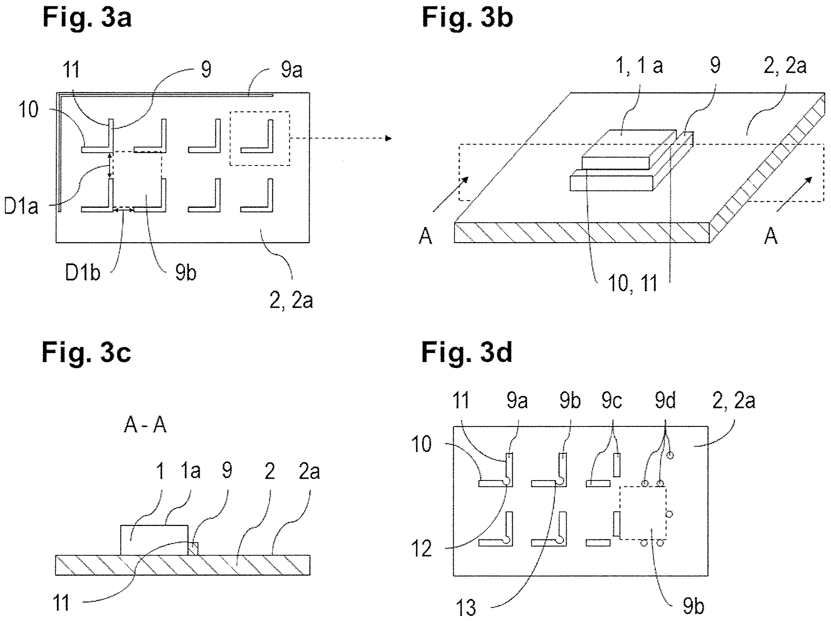

Die Fig. 3a bis 8d zeigen Ausführungsformen, die zur präzisen Anordnung und Ausrichtung der elektronischen Bauteile 1 auf dem Träger 2 dienen. Dies erfolgt nach dem Abgabevorgang in Fig. 1 und vor der Weiterverarbeitung in Fig. 2a oder 2b. Auf diese Weise können mehrere elektronische Bauteile 1 simultan auf dem Träger im Raster des Zielsubstrates feinjustiert werden.

### Erste Ausführungsform

Fig. 3a zeigt eine Draufsicht auf einen Träger 2 mit L-förmigen Ausrichtstrukturen 9 gemäß einer ersten Ausführungsform. Diese Ausrichtstrukturen 9 sind als Vorsprünge auf der Oberseite 2a des Trägers 2 ausgebildet (Fig. 3b), gleichartig ausgerichtet und in einem bestimmten Muster/Raster auf dem Träger 2 verteilt angeordnet. Die Ausrichtstrukturen 9 haben zum Ausrichten eines elektronischen Bauteils 1 eine erste Kante 10 und eine zweite Kante 11, die hier gleich lang sind und im rechten Winkel aufeinandertreffen, sodass sie eine Begrenzung für das elektronische Bauteil 1 darstellen. Vorteilhafterweise bildet eine Ausrichtstruktur 9 zusammen mit unmittelbar benachbarten Ausrichtstrukturen 9 und/oder einer beispielsweise als Wand ausgebildeten Begrenzung 9a eine Aufnahme/Landezone 9b für die nach der Abgabe ungenau auf dem Träger 2 platzierten elektronischen Bauteile 1. Auf diese Weise ist die Aufnahme/Landezone 9b derart definiert, dass das elektronische Bauteil 1 vor dem Ausrichten sicher umgriffen ist, so dass ein Ausrichten möglich ist. Zu diesem Zweck kann die Aufnahme/Landezone 9b durchgehend geschlossen sein oder auch offene Bereiche D1a, D1b aufweisen. Solche offenen Bereiche D1a, D1b können unterschiedlich lang sein, solange der längste von Ihnen kürzer ist als die kürzeste Seite des elektronischen Bauteils 1, um ein Herausgleiten des elektronischen Bauteils 1 aus der Aufnahme/Landezone 9b zu verhindern.

Fig. 3b zeigt eine perspektivische Sicht auf einen Teil des Trägers 2 aus Fig. 3a mit einem an einer Ausrichtstruktur 9 ausgerichteten elektronischen Bauteil 1. Dabei sind zwei im rechten Winkel zueinander stehende Seiten des elektronischen Bauteils 1 mit den beiden komplementären Kanten 10, 11 der Ausrichtstruktur 9 in Anlage. Hierbei ragt das elektronische Bauteil 1 zwar in einer Richtung senkrecht zur Oberseite 2a des Trägers 2 über die Ausrichtstruktur 9 hinaus, kann aber gleichwohl auch niedriger als die Ausrichtstruktur 9 dimensioniert sein. Ebenso ist hier gezeigt, dass die beiden Kanten 10, 11 länger sind als die komplementären Seiten des elektronischen Bauteils 1, was aber nicht zwingend der Fall sein muss. Es ist sehr wohl möglich, dass die Kanten 10, 11 in einer Richtung parallel zur Oberseite 2a des Trägers 2 kürzer sind als die entsprechenden Seiten des elektronischen Bauteils 1. Vorteilhafterweise beträgt diese Länge der Kanten 10, 11 mehr als 50% und weniger als 100% der entsprechenden Länge der jeweiligen in Anlage zu bringenden Seiten des elektronischen Bauteils 1.

Fig. 3c zeigt eine seitliche Schnittansicht der in Fig. 3b gezeigten Schnittebene A-A durch den Träger 2 mit einem Teil der Ausrichtstruktur 9 und dem elektronischen Bauteil 1. Bei dieser Schnittansicht ist zu erkennen, dass das elektronische Bauteil 1 an der Kante 11 der Ausrichtstruktur 9 anliegt und dass das elektronische Bauteil 1 höher ist als die Ausrichtstruktur 9. Die gleiche Anlage in Bezug auf die nicht gezeigte Kante 10 der Ausrichtstruktur 9 ergibt sich auch ohne eine entsprechende Schnittansicht bereits aufgrund der Darstellung in Fig. 3b. Selbstverständlich ist, trotz der gezeigten Anlage des elektronischen Bauteils 1 an einer seitlichen Fläche der Ausrichtstruktur 9, keine Fläche notwendig. Vielmehr ist eine in einem Abstand von der Oberseite 2b des Trägers 2 definierte Kante 11 bereits ausreichend, die in der Lage ist, die Bewegung des elektronischen Bauteils 1 auf dem Träger 2 in eine Richtung entlang der Oberseite 2a des Trägers 2 zu begrenzen. Demzufolge kann der Querschnitt durch die Ausrichtstruktur 9, wie in diesem Fall, rechteckig sein, er kann aber auch jede andere Form haben, solange die beschrieben Kante 10, 11 gebildet ist.

Fig. 3d zeigt vier Modifikationen 9a bis 9d der Ausrichtstruktur 9 der ersten Ausführungsform.

Bei der ersten Modifikation links außen (oben und unten) treffen die beiden Kanten 10, 11 nicht im rechten Winkel aufeinander, um eine Ecke zu bilden, sondern sind über einen Bogen 12 miteinander verbunden. Auf diese Weise wird bei der Herstellung der Ausrichtstruktur 9a das aufwendige Schaffen einer hochgenauen Ecke vermieden.

Bei der zweiten Modifikation Mitte links (oben und unten) gehen beide Kanten 10, 11 mittels nicht gezeigter gebogener Übergänge 13 so in den Bogen 12 der ersten Modifikation über, dass beide Kanten 10, 11 eine durchgehende Kante 10, 11 als Ausrichtstruktur 9b bilden.

Bei der dritten Modifikation Mitte rechts (oben und unten) ist die Ausrichtstruktur 9c mehrteilig. In diesem Fall besteht sie aus zwei Strukturen, die jeweils eine der beiden Kanten 10, 11 bilden und miteinander nur indirekt über den Träger 2 verbunden sind.

Bei der vierten Modifikation rechts außen (oben und unten), sind statt zwei Kanten 10, 11, die parallel zur Oberseite 2a des Trägers 2 verlaufen, mindestens drei senkrecht zur Oberseite 2a des Trägers 2 verlaufende Kanten vorgesehen, beispielsweise als vom Träger 2 ragende Säulenstrukturen 9d, wobei mindestens zwei der Kanten auf einer zur Oberseite 2a des Trägers 2 parallel gedachten Linie angeordnet sind und mindestens eine der Kanten auf einer dazu senkrecht angeordneten, zur Oberseite 2a des Trägers 2 parallel gedachten Linie angeordnet ist, so dass die mindestens drei Kanten der Säulenstrukturen 9d eine L-Form bilden. Selbstverständlich ist auch die umgekehrte Anordnung möglich.

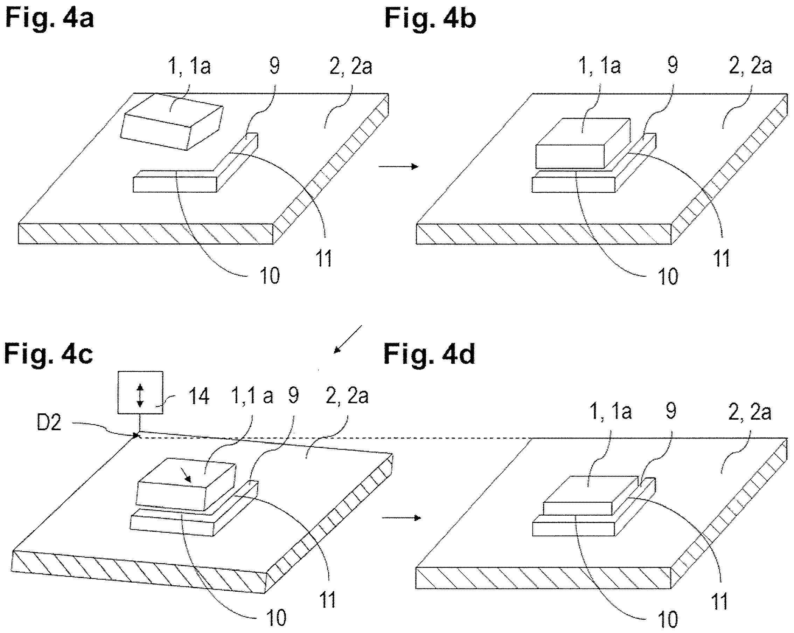

Die Fig. 4a bis 4d zeigen ein Ausrichtverfahren gemäß der ersten Ausführungsform.

In Fig. 4a befindet sich das elektronische Bauteil 1 so im freien Fall auf den Träger 2, dass dieses schließlich zumindest grob nahe einer Ausrichtstruktur 9, vorzugsweise in einer definierten Aufnahme oder Landezone, den Träger 2 berührt.

In Fig. 4b liegt das elektronische Bauteil 1 bereits mit seiner Unterseite 1b auf der Oberseite 2a des Trägers 2 in einem Abstand zur Ausrichtstruktur 9 und innerhalb der Aufnahme oder Landezone.

In Fig. 4c ist der Träger 2 so geneigt, dass das elektronische Bauteil 1 gegen die Ausrichtstruktur 9 gleiten kann. Diese Neigung des Trägers 2 kann von Anfang an bestehen oder auch erst bewirkt werden, nachdem das elektronische Bauteil 1 den Träger 2 berührt hat oder auf diesem zum Liegen gekommen ist. Zu diesem Zweck ist eine Neigungseinrichtung 14 vorgesehen, die den Träger 2 zumindest an einem Punkt passiv angehoben halten oder aktiv heben und senken kann. Hier wird der Träger 2 um einen Abstand D angehoben. Der erforderliche Abstand ist beispielsweise von dem Reibkoeffizienten zwischen dem elektronischen Bauteil 1 und dem Träger 2 sowie dem Gewicht des elektronischen Bauteils 1 und der Größe des Trägers 2 abhängig. Im vorliegenden Fall, in dem der Träger 2 mittels der Neigungseinrichtung 14 aktiv an nur einem Punkt des Trägers 2 angehoben wird, bewirkt dieses Anheben, dass das elektronische Bauteil 1 in Richtung der von den beiden Kanten 10, 11 gebildeten Ecke gleitet. Ebenso kann vorgesehen werden, dass der Träger 2 an mindestens zwei Punkten angehoben und/oder abgesenkt werden kann, um den Träger 2 zu neigen, sodass das elektronische Bauteil 1 zuerst gegen die eine Kante 10 und anschließend auch gegen die andere Kante 11 gleiten kann, damit es sich sowohl mit der ersten als auch mit der zweiten Kante 10, 11 der Ausrichtstruktur 9 in Anlage befindet.

In Fig. 4d ist das elektronische Bauteil 1 bereits mit der Ausrichtstruktur 9 in Anlage, sodass dessen Ausrichtung abgeschlossen ist, wonach der Träger 2 wieder mittels der Neigungseinrichtung 14 in seinen waagerechten Anfangszustand abgesenkt wird.

### Zweite Ausführungsform

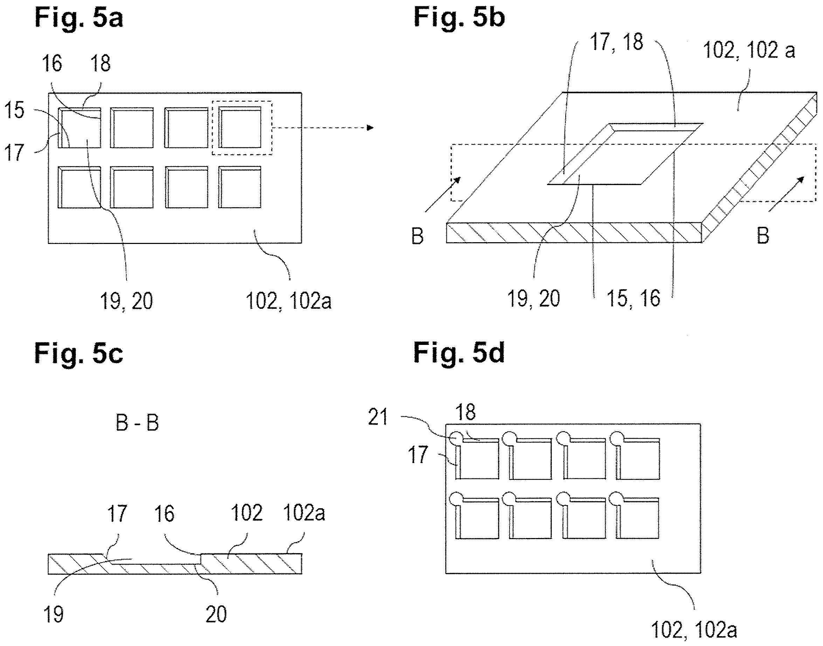

Fig. 5a zeigt eine Draufsicht auf eine Oberseite 102 eines Trägers 102 mit L-förmigen Ausrichtstrukturen 15, 16 und L-förmigen Ausrichteinrichtungen 17, 18 gemäß einer zweiten Ausführungsform. Diese Ausrichtstrukturen 15, 16 und Ausrichteinrichtungen 17, 18 sind Teil einer als Vertiefung im Träger 2 ausgebildeten Aufnahme 19. Dabei sind die Ausrichteinrichtungen 17, 18 schräg von der Oberseite 102a des Trägers 102 zur jeweiligen Ausrichtstruktur 15, 16 abfallende Flächen. Somit verkleinert sich die Aufnahme 19 bis auf ihre Grundfläche 20, die mindestens der Grundfläche, d.h. der Fläche der Unterseite 1b, des auszurichtenden elektronischen Bauteils 1 entspricht. Die anfängliche Fläche der Aufnahme 19, die in einer Ebene mit der Oberseite 102a des Trägers 102 verläuft, ist so bemessen, dass ein ungenau auf den Träger 102 fallendes elektronisches Bauteil 1 immer noch vollständig innerhalb der Aufnahme 19 landet, wenngleich es auch nicht sofort an der Ausrichtstruktur 15, 16 ausgerichtet ist.

Fig. 5b zeigt eine perspektivische Sicht auf die Aufnahme 19 des Trägers 102 aus Fig. 5a. Der als Kanten 15, 16 ausgebildeten Ausrichtstruktur 15, 16 liegt die als geneigte Flächen 17, 18 ausgebildete Ausrichteinrichtung gegenüber.

Fig. 5c zeigt eine seitliche Schnittansicht der in Fig. 5b gezeigten Schnittebene B-B durch den Träger 102 mit einem Teil der Ausrichtstruktur 17 und einem Teil der Ausrichteinrichtung 16. Hier ist insbesondere die geneigte Fläche 17 der Ausrichtstruktur zu erkennen. Außerdem ist eine Dimension der Grundfläche 20 der Aufnahme 19 parallel zur Oberseite 102a des Trägers 102 zu erkennen.

Fig. 5d zeigt eine Modifikation der Ausrichteinrichtungen 17, 18 der zweiten Ausführungsform. Diese betrifft zwar die Ausrichteinrichtung 17, 18, entspricht aber analog der ersten in Fig. 3d gezeigten Modifikation der ersten Ausführungsform. Hierbei treffen die beiden geneigten Flächen 17, 18 nicht in einem Winkel aufeinander, um eine geneigte Ecke zu bilden, sondern sind über einen Bogen 21 miteinander verbunden.

Ebenso lassen sich ohne Weiteres auch die restlichen Modifikationen aus Fig. 3d der ersten Ausführungsform auf diese zweite Ausführungsform anwenden.

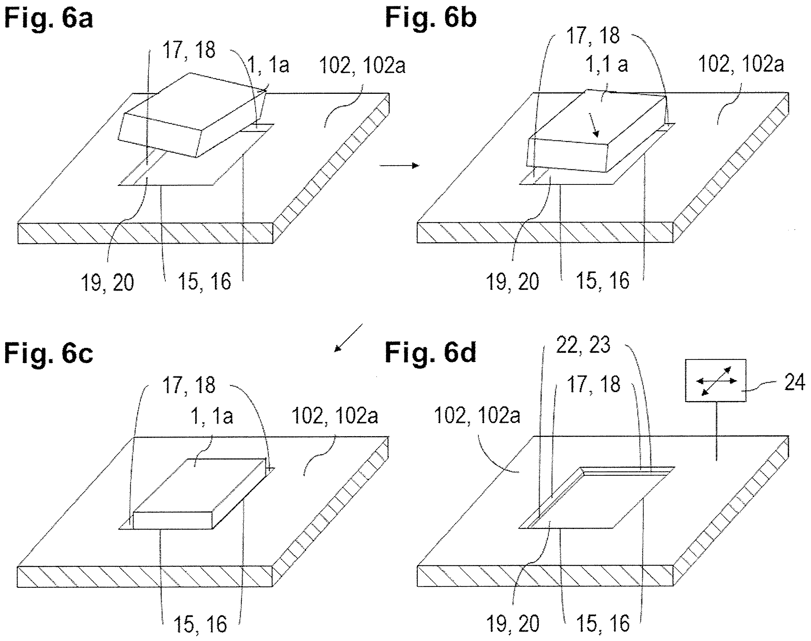

Die Fig. 6a bis 6d zeigen ein Ausrichtverfahren gemäß der zweiten Ausführungsform.

In Fig. 6a befindet sich das elektronische Bauteil 1 im freien Fall auf den Träger 102, sodass dieses innerhalb der Aufnahme 19 landet.

In Fig. 6b ist das elektronische Bauteil 1 so in der Aufnahme 19 gelandet, dass zwei Kanten der Unterseite 1b des elektronischen Bauteils 1 auf den geneigten Flächen 15, 16 der Ausrichteinrichtung 17, 18 liegen. Entlang dieser geneigten Flächen 17, 18 gleitet das elektronische Bauteil 1 schwerkraftgetrieben so in die Aufnahme 19, dass dessen Unterseite 1b auf der Grundfläche 20 der Aufnahme 19 liegt.

In Fig. 6c ist das elektronische Bauteil 1 bereits entlang der geneigten Flächen 17, 18 gegen die Ausrichtstruktur 15, 16 so geglitten und in Anlage gebracht, dass es nunmehr ausgerichtet ist.

In Fig. 6d sind zwei weitere Modifikationen der zweiten Ausführungsform gezeigt.

Bei der ersten Modifikation handelt es sich um eine Unterteilung der geneigten Flächen 17, 18 der Ausrichteinrichtung in, von der Oberseite 102a des Trägers 102 beginnend, einer geneigten Fläche 17, 18 und einer sich daran anschließenden bis zur Grundfläche 20 der Aufnahme 19 reichenden senkrechten Fläche 22, 23.

Bei der zweiten Modifikation handelt es sich um eine Vibrationseinrichtung 24. Mit dieser lässt sich der Träger 102 in Schwingungen versetzen, die derart sind, dass die Ausrichtung des elektronischen Bauteils 1 unterstützt wird, beispielsweise für den Fall des Verkantens innerhalb der Aufnahme 19 oder für den Fall, dass das Gewicht des elektronischen Bauteils 1 zu gering ist, um ein vollständiges Herabgleiten entlang der geneigten Flächen 17, 18 der Ausrichteinrichtung 17, 18 zu gewährleisten.

### Dritte Ausführungsform

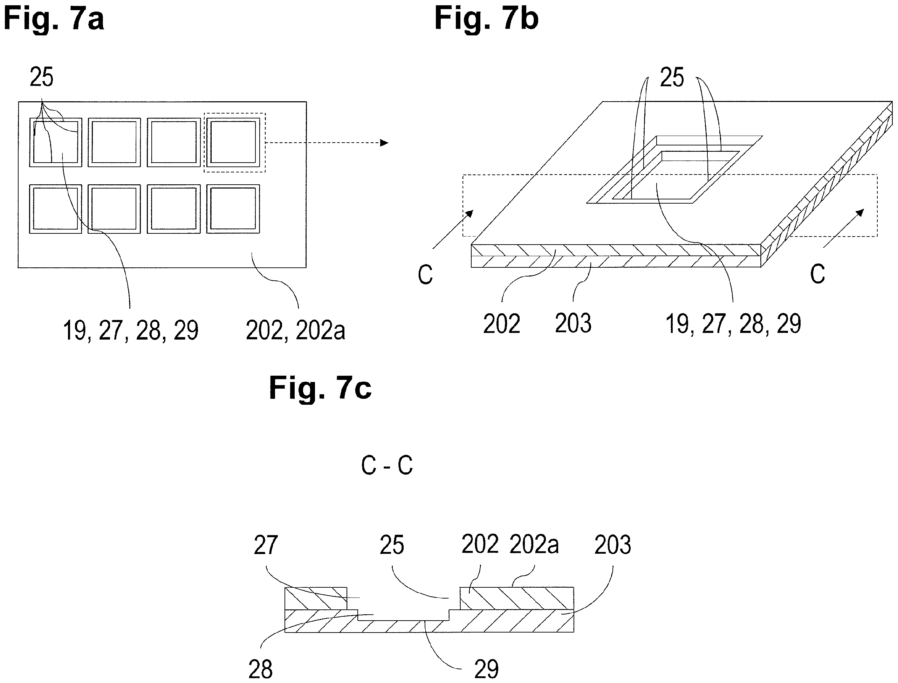

Fig. 7a zeigt eine Draufsicht auf eine Oberseite 202a eines zweiteiligen Trägers 202, 203 (Fig. 7b) mit L-förmigen, rechteckigen oder quadratischen Ausrichtstrukturen 25 gemäß einer dritten Ausführungsform. Dabei definieren zwei übereinanderliegende Trägerplatten 202, 203 den Träger 202, 203, der eine als Vertiefung ausgebildete Aufnahme 19 für ein elektronisches Bauteil 1 aufweist. Die obere Trägerplatte 202 hat eine Durchgangsöffnung 27, deren Fläche in der Ebene der Oberseite 202a der oberen Trägerplatter 202 so dimensioniert ist, dass sie größer als die Fläche der Unterseite 1b des auszurichtenden elektronischen Bauteils 1 ist. Die Durchgangsöffnung 27 führt weiter zu einer Vertiefung 28 in der unteren Trägerplatte 203, wobei diese eine Grundfläche 29 hat, auf welcher das elektronische Bauteils 1 liegen kann und welche eine Fläche hat, die mindestens so groß ist, wie die Unterseite 1b des auszurichtenden elektronischen Bauteils 1, und kleiner ist als die Fläche der Durchgangsöffnung 27, die in einer Ebene mit der Oberseite 202a der oberen Trägerplatte 202 liegt.

Fig. 7b zeigt eine perspektivische Sicht auf einen Teil des Trägers aus Fig. 7a. Dabei sind nicht nur die beiden Trägerplatten 202, 203 zu erkennen, die unmittelbar aufeinander liegen, sondern auch die Durchgangsöffnung 27, die Vertiefung 28 und die Grundfläche 29, welche die Aufnahme 19 bilden.

Fig. 7c zeigt eine seitliche Schnittansicht der in Fig. 7b gezeigten Schnittebene C-C durch den Träger 202, 203 mit einem Teil der Ausrichtstruktur 25, die in Form einer Kante 25 ausgebildet ist. Insbesondere sind die Durchgangsöffnung 27, die Vertiefung 28 und die Grundfläche 29 zu erkennen, welche die Aufnahme 19 bilden.

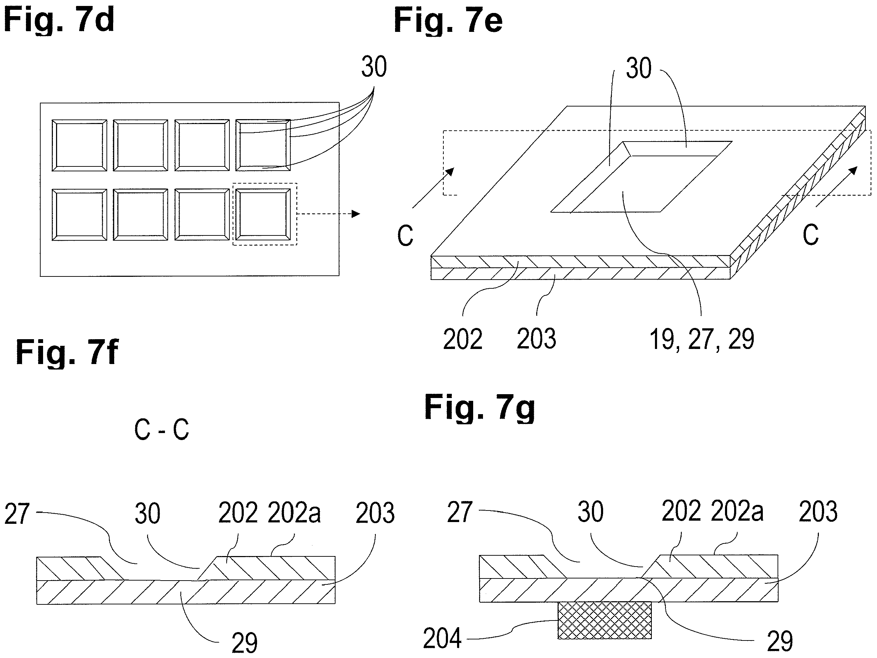

Fig. 7d zeigt eine Modifikation der dritten Ausführungsform. Hierbei ist der Übergang von der Durchgangsöffnung 27 der oberen Trägerplatte 202 zur unteren Trägerplatte 203 nicht gestuft, sondern jeweils durch eine geneigte Fläche 30 ersetzt, die den geneigten Flächen 17, 18 aus der zweiten Ausführungsform entspricht. Durch diese geneigten Flächen 30 hat die Aufnahme insgesamt eine Pyramidenabschnittsförmige Gestalt. Die untere Trägerplatte 203 weist in dieser Ausführungsform keine Vertiefungen auf, sodass die Grundfläche 29, auf welcher das Bauteil 1 liegen kann, durch die Durchgangsöffnung 27 bzw. durch die geneigten Flächen 30 definiert ist. Die Grundfläche 29 bildet somit eine ebene Auflagefläche für das Bauteil.

In einer Weiterbildung (nicht gezeigt) kann die Durchgangsöffnung aus einer Kombination von geneigten Flächen und Stufungen gebildet sein. Insbesondere können hierbei geneigte Flächen, welche an der Oberseite des Trägers angeordnet sind, einen ersten Teil der Durchgangsöffnung ausbilden. Sich jeweils an die geneigten Flächen anschließende und bis zur Grundfläche reichende senkrechte Flächen können, analog zum Beispiel zu den in Fig. 6d gezeigten Flächen 22 und 23, einen zweiten Teil der Durchgangsöffnung ausbilden.

Fig. 7e zeigt eine perspektivische Sicht auf einen Teil des modifizierten Trägers aus Fig. 7d. Dabei sind nicht nur die beiden Trägerplatten 202, 203 zu erkennen, die unmittelbar aufeinander liegen, sondern auch die Durchgangsöffnung 27 mit den geneigten Flächen 30, welche die Aufnahme bildet.

Fig. 7f zeigt eine seitliche Schnittansicht der in Fig. 7e gezeigten Schnittebene C-C durch den modifizierten Träger 202, 203 mit den geneigten Flächen 30, welche in der Modifikation der dritten Ausführungsform als Ausrichtstruktur dienen. Insbesondere sind die Durchgangsöffnung 27 und die Grundfläche 29 zu erkennen, welche die Aufnahme bilden.

Fig. 7g zeigt eine Weiterbildung der Modifikation der dritten Ausführungsform. Ein Magnet 204 ist auf der der Durchgangsöffnung 27 abgewandten Seite der unteren Trägerplatte 203 angeordnet. Der Magnet 204 ruft ein magnetisches Feld hervor, welches eine magnetische Kraft auf das insbesondere ferromagnetische elektronische Bauteil 1 ausübt. Hierdurch wird eine Ausrichtung des ferromagnetischen elektronischen Bauteils 1 an der Ausrichtstruktur befördert.

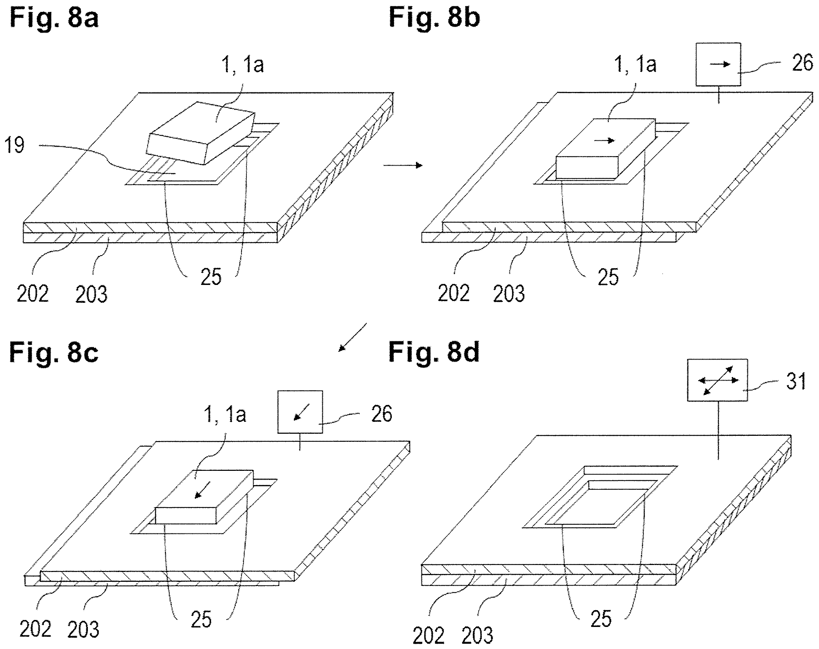

Die Fig. 8a bis 8d zeigen ein Ausrichtverfahren gemäß der dritten Ausführungsform.

In Fig. 8a befindet sich das elektronische Bauteil 1 im freien Fall auf den Träger 202, 203, sodass dieses innerhalb der Aufnahme 19 landet.

In Fig. 8b liegt das elektronische Bauteil 1 mit der Unterseite 1b auf der Grundfläche 29 der unteren Trägerplatte 203. Mittels einer Ausrichteinrichtung 26, welche die obere Trägerplatte 202 entlang der unteren Trägerplatte 203 in Richtung einer ersten Kante 25 der Ausrichtstruktur 25 verschiebt, wird das elektronische Bauteil 1 zuerst an dieser ersten Kante 25 ausgerichtet.

In Fig. 8c wird anschließend das elektronische Bauteil 1 mittels der Ausrichteinrichtung 26 mit einer zweiten Kante 25 der Ausrichtstruktur 25 in Anlage gebracht, indem die obere Trägerplatte 202 zusätzlich entlang der unteren Trägerplatte 203 in Richtung dieser zweite Kante 25 weiteren Kante verschoben wird.

In Fig. 8d ist eine weitere Modifikation der dritten Ausführungsform gezeigt, bei der die Ausrichtung des elektronischen Bauteils 1 zusätzlich mittels einer Vibrationseinrichtung 31 erfolgt, die ähnlich der Vibrationseinrichtung 24 der zweiten Ausführungsform funktioniert. Diese Vibrationseinrichtung 24 stellt sicher, dass das elektronische Bauteil 1 nicht innerhalb der Aufnahme 19 verkantet und vollständig auf der Grundfläche 29 landet.

Aus der dritten Ausführungsform ist zu erkennen, dass lediglich eine L-förmige Ausrichtstruktur 25 verwendet wird, welche von der unteren und rechten Kante 25 in der unteren Trägerplatte 203 gebildet ist. Gleichwohl kann auch jede andere Kombination von zwei im Winkel zueinander stehender Kanten 25 verwendet werden. So ergeben sich im vorliegenden Fall gleich vier mögliche Ausrichtstrukturen 25. Ist etwa die untere Trägerplatte 203 auch noch gegenüber der oberen Trägerplatte 202 mittels der Ausrichteinrichtung 26 bewegbar, so ergeben sich 8 L-förmige Ausrichtstrukturen, da ein in der Aufnahme 19 befindliches elektronisches Bauteil 1 auch an den Kanten der oberen Trägerplatte 202 ausgerichtet werden kann. Auf diese Weise lassen sich mit einem Träger 202, 203 unterschiedliche elektronische Bauteile 1 ausrichten.

Eine Modifikation der dritten Ausführungsform besteht darin, einen mehrteiligen Träger 202, 203 vorzusehen, bei dem die Trägerplatten 202, 203 nicht (nur) übereinander, sondern (auch) auf einer Ebene nebeneinander angeordnet sind. Diese Trägerplatten können entlang einer Grundfläche 20 aufeinander zu und voneinander weg verschoben werden, um eine variable Aufnahme 19, ähnlich der zweiten Ausführungsform, zwischen sich zu definieren. Die gegenseitige Verschiebung führt gleichzeitig zu einer Ausrichtung des innerhalb der Aufnahme 19 befindlichen elektronischen Bauteils 1. Auf diese Weise kann die Höhe des Trägers 202, 203 reduziert werden und/oder eine variablere Aufnahme 19 geschaffen werden, die sich besser unterschiedlichen Größen elektronischer Bauteile 1 anpassen lässt.

Die Verteilung von Anschlüssen des auf dem Träger 2, 102, 202, 203 ausgerichteten elektronischen Bauteils 1 soll bei den obigen Ausführungsformen unter Berücksichtigung der Art der Weiterverarbeitung gemäß Fig. 2a oder Fig. 2b der geometrischen Verteilung komplementärer Anschlusskontakte auf einem vorgesehenen Zielsubstrat entsprechen. Gleiches gilt für eine Vielzahl ausgerichteter elektronischer Bauteile 1.

## Patentansprüche

1. System zum Ausrichten eines elektronischen Bauteils (1) mit:
- einer Vorrichtung zum Ausrichten des elektronischen Bauteils (1) mit:
- einem Träger (2; 102; 202, 203) mit einer Ausrichtstruktur (9, 10, 11; 15, 16; 25) für ein elektronisches Bauteil (1), und
- einer Ausrichteinrichtung (14; 17, 18; 26) zum Ausrichten des elektronischen Bauteils (1) an der Ausrichtstruktur (9, 10, 11; 15, 16; 25), wobei die Ausrichtstruktur (9, 10, 11; 15, 16; 25) eine erste und eine zweite Kante (10, 11; 15, 16; 25) definiert, die im Winkel zueinander stehen und zu zwei im gleichen Winkel zueinander stehenden Seiten des auszurichtenden elektronischen Bauteils (1) komplementär sind, wobei
die Ausrichteinrichtung (14; 17, 18; 26) dazu eingerichtet ist, das elektronische Bauteil (1) an der Ausrichtstruktur (9, 10, 11; 15, 16; 25) durch in Anlage bringen von Seiten des elektronischen Bauteils (1) sowohl mit der ersten als auch mit der zweiten Kante (10, 11; 15, 16; 25) der Ausrichtstruktur (9, 10, 11; 15, 16; 25) auszurichten; und
- einer Abgabeeinrichtung (3), die dazu eingerichtet ist, das elektronisches Bauteil (1) an einer Abgabestelle über der Vorrichtung zum Ausrichten des elektronischen Bauteils nahe der Ausrichtstruktur (9, 10, 11; 15, 16; 25) abzugeben; und
- einer Aufnahmeeinrichtung (6; 7, 8), die dazu eingerichtet ist, das in der Vorrichtung an der Ausrichtstruktur (9, 10, 11; 15, 16; 25) ausgerichtete elektronische Bauteil (1) aufzunehmen, wobei
(i) die Abgabeeinrichtung (3) ein Laser ist, der dazu eingerichtet ist, das elektronische Bauteile (1) von einer auf einem Wafer (4) aufgebrachten Trägerfolie mittels Wärmeerzeugung zu lösen, wobei die Trägerfolie eine Folie mit thermisch freigebendem Haftklebstoff oder eine Folie mit auf UV-Bestrahlung freigebendem Haftklebstoff ist;
(ii) die Abgabestelle vom Träger (2; 102; 202, 203) derart beabstandet ist, dass das elektronische Bauteil (1) dazwischen frei fallen kann; und
(iii) die Aufnahmeeinrichtung (6) ein Transferwerkzeug ist, das dazu eingerichtet ist, das ausgerichtete elektronische Bauteil (1) temporär aufzunehmen oder
(iv) die Aufnahmeeinrichtung (7, 8) ein Substrat ist, das dazu eingerichtet ist, das ausgerichtete elektronische Bauteil (1) permanent aufzunehmen, wobei als ein Verbindungsmittel (7) am Substrat (8) flüssiger Klebstoff vorgesehen ist.

2. System nach Anspruch 1, wobei
der Träger (2; 102; 202, 203) eine Vielzahl Ausrichtstrukturen (9, 10, 11; 15, 16; 25) in einer bestimmten geometrischen Verteilung für eine Vielzahl auszurichtender elektronischer Bauteile (1) aufweist, wobei vorzugsweise
die Ausrichteinrichtung (14; 17, 18; 26) dazu eingerichtet ist, das elektronische Bauteil (1) an der Ausrichtstruktur (9, 10, 11; 15, 16; 25) passiv und/oder aktiv auszurichten.

3. System nach einem der vorhergehenden Ansprüche, wobei die Ausrichteinrichtung (14; 17, 18) eine Neigungseinrichtung (14; 17, 18) aufweist, die dazu eingerichtet ist, das elektronische Bauteil (1) an der Ausrichtstruktur (9, 10, 11; 15, 16) auszurichten, wobei vorzugsweise
(i) die Neigungseinrichtung (14) dazu eingerichtet ist, den Träger (2) aus einer waagerechten Lage an mindestens einem Punkt zu heben und/oder zu senken, um das elektronische Bauteil (1) aufgrund der Neigung an der Ausrichtstruktur (9, 10, 11) auszurichten, und/oder
(ii) die Neigungseinrichtung (17, 18) mindestens eine am Träger (102) angeordnete zur Ausrichtstruktur (15, 16) geneigte Fläche aufweist.

4. System nach einem der vorhergehenden Ansprüche, wobei der Träger (202, 203) zwei vorzugsweise übereinanderliegende Trägerplatten (202, 203) aufweist, die zusammen eine Aufnahme (19) für das elektronische Bauteil (1) definieren und dazu eingerichtet sind, gegeneinander vorzugsweise in mindestens eine Richtung verschoben zu werden, um das elektronische Bauteil (1) an der Ausrichtstruktur (25) auszurichten.

5. System nach einem der vorhergehenden Ansprüche, wobei
(i) die Ausrichteinrichtung (14; 17, 18; 26) eine Vibrationseinrichtung (24; 31) aufweist, welche dazu eingerichtet ist, das elektronische Bauteil (1) mittels Vibrationen des Trägers (2; 102; 202, 203) an der Ausrichtstruktur (9, 10, 11; 15, 16; 25) auszurichten, und/oder
(ii) die Ausrichtstruktur (9, 10, 11; 15, 16; 25) L-förmig, rechteckig oder quadratisch ist.

6. System nach einem der vorherigen Ansprüche, wobei
die von den zwei vorzugsweise übereinanderliegenden Trägerplatten (202, 203) definierte Aufnahme (19) für das elektronische Bauteil (1) eine konische Form, insbesondere eine Kegelabschnittsform oder eine Pyramidenabschnittsform, mit einer ebenen Auflagefläche aufweist.

7. System nach einem der vorherigen Ansprüche, wobei
die Ausrichteinrichtung (14; 17, 18; 26) einen Magneten (204) aufweist, welcher dazu angeordnet und ausgebildet ist, ein magnetisches Feld hervorzurufen, welches eine magnetische Kraft auf das, insbesondere ferromagnetische, elektronische Bauteil (1) ausübt, welche das Ausrichten des elektronischen Bauteils (1) an der Ausrichtstruktur (9, 10, 11; 15, 16; 25) zumindest befördert.

8. System nach einem der vorherigen Ansprüche, wobei
die Abgabestelle vom Träger (2; 102; 202, 203) derart beabstandet ist, dass das elektronische Bauteil (1) dazwischen frei fallen kann, und/oder als der flüssige Klebstoff Silberleitpaste per Siebdruck vorgesehen ist.

9. Verfahren zum Ausrichten eines elektronischen Bauteils (1), das ein System nach einem der vorhergehenden Ansprüche verwendet, mit den Schritten:
- Abgeben des elektronischen Bauteils (1) an einer Abgabestelle über der Vorrichtung zum Ausrichten nahe einer Ausrichtstruktur (9, 10, 11; 15, 16; 25);
- Landen des mindestens einen elektronischen Bauteils (1) nach einer Freifallphase innerhalb einer Aufnahme (9b, 19) an einer Oberseite (2a; 102a; 202a) eines Trägers (2; 102; 202, 203),
- Ausrichten des auf dem Träger (2; 102; 202, 203) befindlichen elektronischen Bauteils (1) an der Ausrichtstruktur (9, 10, 11; 15, 16; 25) mittels einer Ausrichteinrichtung (14; 17, 18; 26), wobei die Ausrichtstruktur (9, 10, 11; 15, 16; 25) eine erste und eine zweite Kante (10, 11; 15, 16; 25) definiert, die im Winkel zueinander stehen und zu zwei im gleichen Winkel zueinander stehenden Seiten des auszurichtenden elektronischen Bauteils (1) komplementär sind;
- in Anlage bringen von Seiten des elektronischen Bauteils (1) sowohl mit der ersten als auch mit der zweiten Kante (10, 11; 15, 16; 25) der Ausrichtstruktur (9, 10, 11; 15, 16; 25) um das elektronische Bauteil (1) an der Ausrichtstruktur (9, 10, 11; 15, 16; 25) auszurichten;
- Verschieben des elektronischen Bauteils (1) beim Ausrichten auf dem Träger (2; 102; 202, 203) mittels der Ausrichteinrichtung (14; 17, 18; 26), sodass zwei im Winkel zueinander stehende Seiten des elektronischen Bauteils (1) sowohl an einer ersten als auch an einer zweite Kante (10, 11; 15, 16; 25) der Ausrichtstruktur (9, 10, 11; 15, 16; 25) anliegen;
- Aufnehmen des in der Vorrichtung an der Ausrichtstruktur (9, 10, 11; 15, 16; 25) ausgerichteten elektronischen Bauteils (1) in einer Aufnahmeeinrichtung (6; 7, 8), wobei die Aufnahmeeinrichtung (6) ein Transferwerkzeug ist, das dazu eingerichtet ist, das ausgerichtete elektronische Bauteil (1) temporär aufzunehmen, oder die Aufnahmeeinrichtung (7, 8) ein Substrat ist, das dazu eingerichtet ist, das ausgerichtete elektronische Bauteil (1) permanent aufzunehmen, wobei als ein Verbindungsmittel (7) am Substrat (8) flüssiger Klebstoff verwendet wird.

## Claims

1. A system for aligning an electronic component (1), comprising:
- an apparatus for aligning the electronic component (1), comprising:
- a carrier (2; 102; 202, 203) with an alignment structure (9, 10, 11; 15, 16; 25) for an electronic component (1), and
- an alignment device (14; 17, 18; 26) for aligning the electronic component (1) at the alignment structure (9, 10, 11; 15, 16; 25), wherein the alignment structure (9, 10, 11; 15, 16; 25) defines a first and a second edge (10, 11; 15, 16; 25) which are at an angle to each other and are complementary to two sides of the electronic component (1) to be aligned, which are at the same angle to each other, wherein
the alignment device (14; 17, 18; 26) is adapted to align the electronic component (1) at the alignment structure (9, 10, 11; 15, 16; 25) by bringing into contact sides of the electronic component (1) both with the first and the second edge (10, 11; 15, 16; 25) of the alignment structure (9, 10, 11; 15, 16; 25); and
- a submission device (3) which is adapted to submit the electronic component (1) at a submission point via the apparatus for aligning the electronic component near the alignment structure (9, 10, 11; 15, 16; 25); and
- an accommodation device (6; 7, 8) which is adapted to accommodate the electronic component (1) which is aligned in the apparatus at the alignment structure (9, 10, 11; 15, 16; 25), wherein
(I) the submission device (3) is a laser which is adapted to release the electronic component (1) from a carrier tape applied on a wafer (4) by means of heat generation, wherein the carrier tape is a thermal release tape or a UV radiation release tape;
(II) the submission point is spaced from the carrier (2; 102; 202, 203) in such a manner that the electronic component (1) can freely fall in between; and
(III) the accommodation device (6) is a transfer tool which is adapted to temporarily accommodate the electronic component (1), or
(IV) the accommodation device (7, 8) is a substrate which is adapted to permanently accommodate the aligned electronic component (1), wherein liquid adhesive is provided as a joining agent.

2. The system according to Claim 1, wherein
the carrier (2; 102; 202, 203) comprises a plurality of alignment structures (9, 10, 11; 15, 16; 25) in a specific geometric distribution for a plurality of electronic components (1) to be aligned, wherein preferably the alignment device (14; 17, 18; 26) is adapted to align the electronic component (1) passively and/or actively at the alignment structure (9, 10, 11; 15, 16; 25).

3. The system according to any of the previous claims, wherein
the alignment device (14; 17, 18) comprises a tilting device (14; 17, 18) which is adapted to align the electronic component (1) at the alignment structure (9, 10, 11; 15, 16), wherein preferably
(I) the tilting device (14) is adapted to raise and/or lower the carrier from the horizontal position at at least one point in order to align the electronic component (1) due to the inclination at the alignment structure (9, 10, 11), and/or
(II) the tilting device (17, 18) comprises at least one surface which is arranged at the carrier (102) and inclined towards the alignment structure (15, 16).

4. The system according to any of the previous claims, wherein
the carrier (202, 203) comprises two carrier plates (202, 203) preferably lying on top of each other, which together define an accommodation (19) for the electronic component (1) and are adapted to be displaced against one another preferably in at least one direction in order to align the electronic component (1) at the alignment structure (25).

5. The system according to any of the previous claims, wherein
(I) the alignment device (14; 17, 18; 26) comprises a vibration device (24; 32) which is adapted to align the electronic component (1) at the alignment structure (9, 10, 11; 15, 16; 25) by means of vibrations of the carrier (2; 102; 202, 203), and/or
(II) the alignment structure (9, 10, 11; 15, 16; 25) is L-shaped, rectangular or square.

6. The system according to any of the previous claims, wherein
the accommodation (19) for the electronic component (1) which is defined by the two carrier plates (202, 203) preferably lying on top of each other exhibits a conical shape, in particular a cone portion shape or a pyramid portion shape, with a plane support surface.

7. The system according to any of the previous claims, wherein
the alignment device (14; 17, 18; 26) comprises a magnet (204) which is arranged and configured to induce a magnetic field which exerts a magnetic force on the, in particular ferromagnetic, electronic component (1), which at least enhances the alignment of the electronic component (1) at the alignment structure (9, 10, 11; 15, 16; 25).

8. The system according to any of the previous claims, wherein
the submission point is spaced from the carrier (2; 102; 202, 203) in such a manner that the electronic component (1) can freely fall in between, and/or silver conductive paste per screen print is provided as the liquid adhesive.

9. A method for aligning an electronic component (1), which employs a system according to any of the previous claims, comprising the steps:
- submitting the electronic component (1) at a submission point via the apparatus for aligning near an alignment structure (9, 10, 11; 15, 16; 25);
- landing of the at least one electronic component (1) after a free-fall phase within a reception means (9b, 19) at an upper side (2a; 102a; 202a) of a carrier (2; 102; 202, 203),
- aligning the electronic component (1) located on the carrier (2; 102; 202, 203) at the alignment structure (9, 10, 11; 15, 16; 25) by means of an alignment device (14; 17, 18; 26), wherein the alignment structure (9, 10, 11; 15, 16; 25) defines a first and a second edge (10, 11; 15, 16; 25) which are at an angle to each other and are complementary to two sides of the electronic component (1) to be aligned, which are at the same angle to each other;
- bringing into contact sides of the electronic component (1) both with the first and the second edge (10, 11; 15, 16; 25) of the alignment structure (9, 10, 11; 15, 16; 25) in order to align the electronic component (1) at the alignment structure (9, 10, 11; 15, 16; 25);
- moving the electronic component (1) during alignment on the carrier (2; 102; 202, 203) so that two sides of the electronic component (1), which are at an angle to each other, are in contact with both a first and a second edge (10, 11; 15, 16; 25) of the alignment structure (9, 10, 11; 15, 16; 25);
- accommodating the electronic component (1) which was aligned in the apparatus at the in an accommodation device (6; 7, 8) the electronic component (1) at alignment structure (9, 10, 11; 15, 16; 25) in an accommodation device (6; 7, 8), wherein the accommodation device (6) is a is a transfer tool which is adapted to temporarily accommodate the electronic component (1), or the accommodation device (7, 8) is a substrate which is adapted to permanently accommodate the aligned electronic component (1), wherein liquid adhesive is provided on the substrate as a joining agent (7).

## Revendications

1. Système pour aligner un composant électronique (1) comprenant :
- un dispositif d'alignement du composant électronique (1) comprenant :
- un support (2 ; 102 ; 202, 203) avec une structure d'alignement (9, 10, 11 ; 15, 16 ; 25) pour un composant électronique (1) et
- un moyen d'alignement (14 ; 17, 18 ; 26) pour aligner le composant électronique (1) avec la structure d'alignement (9, 10, 11 ; 15, 16 ; 25), la structure d'alignement (9, 10, 11 ; 15, 16 ; 25) définissant un premier et un deuxième bord (10, 11 ; 15, 16 ; 25) qui forment un angle entre eux et sont complémentaires à deux côtés du composant électronique (1) à aligner qui forment le même angle entre eux,
le moyen d'alignement (14 ; 17, 18 ; 26) étant conçu pour aligner le composant électronique (1) sur la structure d'alignement (9, 10, 11 ; 15, 16 ; 25) en amenant les côtés du composant électronique (1) en contact à la fois avec le premier et le deuxième bord (10, 11 ; 15, 16 ; 25) de la structure d'alignement (9, 10, 11 ; 15, 16 ; 25) ; et
- un moyen de livraison (3) qui est conçu pour livrer le composant électronique (1) à un point de livraison situé au-dessus du dispositif d'alignement du composant électronique, à proximité de la structure d'alignement (9, 10, 11 ; 15, 16 ; 25) ; et
- un moyen de réception (6 ; 7, 8) qui est conçu pour recevoir le composant électronique (1) aligné sur la structure d'alignement (9, 10, 11 ; 15, 16 ; 25) dans le dispositif, dans lequel
(i) le moyen de livraison (3) est un laser qui est conçu pour libérer le composant électronique (1) d'un film porteur appliqué sur une plaquette (4) au moyen d'une production de chaleur, le film de support étant un film avec un adhésif à libération thermique ou un film avec un adhésif à libération par rayonnement UV ;
(ii) le point de livraison est espacé du support (2 ; 102 ; 202, 203) de telle sorte que le composant électronique (1) peut tomber librement entre eux ; et
(iii) le moyen de réception (6) est un outil de transfert qui est conçu pour recevoir de manière temporaire le composant électronique aligné (1) ou
(iv) le moyen de réception (7, 8) est un substrat qui est conçu pour recevoir de manière permanente le composant électronique aligné (1), un adhésif liquide étant prévu comme agent de liaison (7) sur le substrat (8).

2. Système selon la revendication 1, dans lequel
le support (2 ; 102 ; 202, 203) comprend une pluralité de structures d'alignement (9, 10, 11 ; 15, 16 ; 25) dans une répartition géométrique définie pour une pluralité de composants électroniques (1) à aligner, dans lequel, de préférence,
le moyen d'alignement (14 ; 17, 18 ; 26) est conçu pour aligner de manière passive et/ou active le composant électronique (1) sur la structure d'alignement (9, 10, 11 ; 15, 16 ; 25).

3. Système selon l'une des revendications précédentes, dans lequel le moyen d'alignement (14 ; 17, 18) comprend un moyen d'inclinaison (14 ; 17, 18) qui est conçu pour aligner le composant électronique (1) sur la structure d'alignement (9, 10, 11 ; 15, 16 ; 25), dans lequel, de préférence,
(i) le moyen d'inclinaison (14) est conçu pour lever et/ou abaisser le support (2) à partir d'une position horizontale en au moins un point afin d'aligner le composant électronique (1) sur la structure d'alignement (9, 10, 11) sur la base de l'inclinaison et/ou
(ii) le moyen d'inclinaison (17, 18) comprend au moins une surface disposée sur le support (102) et inclinée par rapport à la structure d'alignement (15, 16).

4. Système selon l'une des revendications précédentes, dans lequel
le support (202, 203) comprend deux plaques de support (202, 203) de préférence superposées qui définissent ensemble un réceptacle (19) pour le composant électronique (1) et qui sont conçues pour être déplacées l'une par rapport à l'autre de préférence dans au moins une direction afin d'aligner le composant électronique (1) sur la structure d'alignement (25).

5. Système selon l'une des revendications précédentes, dans lequel
(i) le moyen d'alignement (14 ; 17, 18 ; 26) comprend un moyen de vibration (24 ; 31) qui est conçu pour aligner le composant électronique (1) sur la structure d'alignement (9, 10, 11 ; 15, 16 ; 25) au moyen de vibrations du support (2 ; 102 ; 202, 203) et/ou
(ii) la structure d'alignement (9, 10, 11 ; 15, 16 ; 25) est en forme de L, rectangulaire ou carrée.

6. Système selon l'une des revendications précédentes, dans lequel
le réceptacle (19) pour le composant électronique (1) défini par les deux plaques de support (202, 203) de préférence superposées a une forme conique, en particulier une forme de tronc de cône ou une forme de tronc de pyramide, avec une surface d'appui plane.

7. Système selon l'une des revendications précédentes, dans lequel
le moyen d'alignement (14 ; 17, 18 ; 26) comprend un aimant (204) qui est disposé et conçu pour produire un champ magnétique qui exerce une force magnétique sur le composant électronique (1), en particulier ferromagnétique, qui favorise au moins l'alignement du composant électronique (1) sur la structure d'alignement (9, 10, 11 ; 15, 16 ; 25).

8. Système selon l'une des revendications précédentes, dans lequel
le point de livraison est espacé du support (2 ; 102 ; 202, 203) de telle sorte que le composant électronique (1) peut tomber librement entre eux et/ou une pâte conductrice à l'argent appliquée par sérigraphie est prévue comme adhésif liquide.

9. Procédé pour aligner un composant électronique (1) qui utilise un système selon l'une des revendications précédentes, comprenant les étapes de :
- livraison du composant électronique (1) à un point de livraison situé au-dessus du dispositif d'alignement, à proximité d'une structure d'alignement (9, 10, 11 ; 15, 16 ; 25) ;
- atterrissage dudit au moins un composant électronique (1) après une phase de chute libre dans un réceptacle (9b, 19) sur une face supérieure (2a ; 102a ; 202a) d'un support (2 ; 102 ; 202, 203),
- alignement du composant électronique (1) situé sur le support (2 ; 102 ; 202, 203) sur la structure d'alignement (9, 10, 11 ; 15, 16 ; 25) à l'aide d'un moyen d'alignement (14 ; 17, 18 ; 26), la structure d'alignement (9, 10, 11 ; 15, 16 ; 25) définissant un premier et un deuxième bord (10, 11 ; 15, 16 ; 25) qui forment un angle entre eux et sont complémentaires à deux côtés du composant électronique (1) à aligner qui forment le même angle entre eux ;
- mise en contact de côtés du composant électronique (1) à la fois avec le premier et le deuxième bord (10, 11 ; 15, 16 ; 25) de la structure d'alignement (9, 10, 11 ; 15, 16 ; 25) afin d'aligner le composant électronique (1) sur la structure d'alignement (9, 10, 11 ; 15, 16 ; 25) ;
- déplacement du composant électronique (1) lors de l'alignement sur le support (2 ; 102 ; 202, 203) à l'aide du moyen d'alignement (14 ; 17, 18 ; 26) de telle sorte que deux côtés du composant électronique (1) formant un angle entre eux viennent en contact à la fois avec un premier et un deuxième bord (10, 11 ; 15, 16 ; 25) de la structure d'alignement (9, 10, 11 ; 15, 16 ; 25) ;
- réception du composant électronique (1) aligné sur la structure d'alignement (9, 10, 11 ; 15, 16 ; 25) dans le dispositif dans un moyen de réception (6 ; 7, 8), le moyen de réception (6) étant un outil de transfert conçu pour recevoir de manière temporaire le composant électronique aligné (1) ou le moyen de réception (7, 8) étant un substrat conçu pour recevoir de manière permanente le composant électronique aligné (1), un adhésif liquide étant utilisé comme agent de liaison (7) sur le substrat (8).
